# FASCICULE DE BREVET EUROPEEN

(11) **EP 2 791 971 B1**
(45) Date de publication et mention de la délivrance du brevet: **31.08.2016**
(21) Numéro de dépôt: 12810386.8
(22) Date de dépôt: 11.12.2012
(51) Int. Cl.: H01L 23/473, H05K 7/20

(54) **DISPOSITIF ELECTRONIQUE AVEC REFROIDISSEMENT PAR SPREADER A METAL LIQUIDE**
ELEKTRONISCHE VORRICHTUNG MIT KÜHLUNG DURCH EIN FLÜSSIGMETALLVERTEILER
ELECTRONIC DEVICE WITH COOLING BY A LIQUID METAL SPREADER

(30) Priorité: 13.12.2011 FR 1161543
(43) Date de publication de la demande: 22.10.2014
(73) Titulaire: Labinal Power Systems, 31700 Blagnac (FR); Institut Polytechnique de Grenoble, 38500 Grenoble (FR); Centre National de la Recherche Scientifique, 75016 Paris (FR)
(72) Inventeur: SALAT, Jacques, F-77170 Brie Comte Robert (FR); AVENAS, Yvan, F-38320 Poisat (FR); MEURET, Régis, Bernard, Albert, F-77000 La Rochette (FR); TAWK, Mansour, F-38100 Grenoble (FR)
(74) Mandataire: Ahner, Philippe
(86) Numéro de dépôt international: PCT/FR2012/052873
(87) Numéro de publication internationale: WO 2013/088054

(56) Documents cités:
- US-A1- 2006 158 849
- US-A1- 2010 066 178
- US-A1- 2011 180 238

## Description

### DOMAINE TECHNIQUE

L'invention concerne un dispositif électronique, par exemple à semi-conducteur, avec refroidissement par spreader à métal liquide.

### ÉTAT DE LA TECHNIQUE ANTÉRIEURE

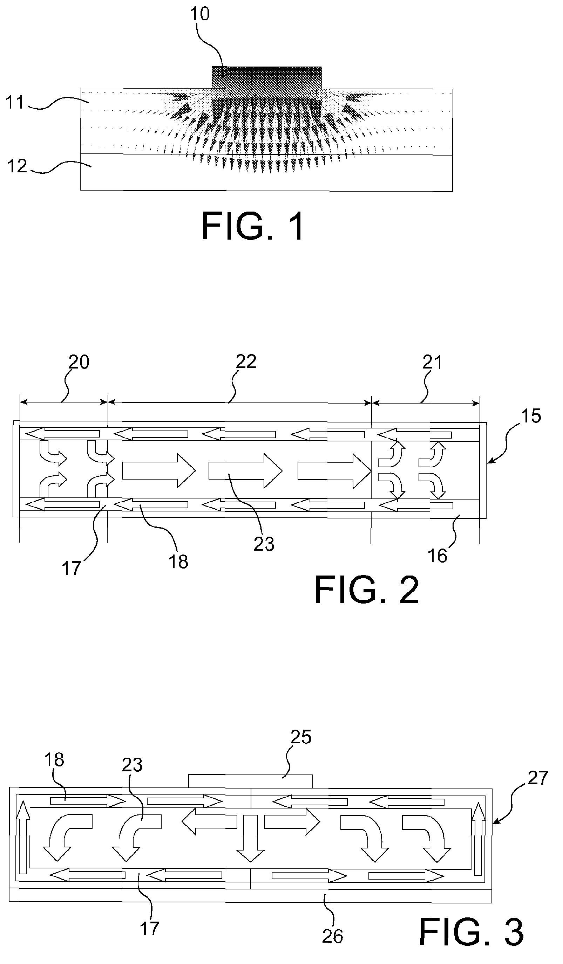

Le domaine de l'invention est celui de la gestion thermique de composants électroniques, par exemple semi-conducteurs. Comme illustré sur la figure 1, un composant électronique peut être disposé sur un dispositif de refroidissement par l'intermédiaire d'une plaque métallique de quelques millimètres d'épaisseur. Cette plaque a pour objet d'épanouir le flux de chaleur émis et ainsi d'augmenter la section de passage de ce flux de chaleur vue par le dispositif de refroidissement. Les gradients de température étant inversement proportionnels à la surface d'échange, la gestion thermique globale s'en trouve largement améliorée. Dans la suite on utilise la dénomination « spreader » pour désigner une telle plaque. La figure 1 illustre une source de dissipation 10, par exemple un composant électronique ou un ensemble de composants en boîtier, disposée sur un spreader 11, qui permet au flux de s'épanouir avant d'arriver au dispositif de refroidissement 12 (les flèches représentent la direction de la densité de flux de chaleur φ). Un tel spreader a une épaisseur optimale : en dessous de cette valeur, l'épanouissement n'est pas suffisant ce qui dégrade les performances du dispositif de refroidissement. Au dessus de cette valeur, la résistance thermique apportée par celui-ci devient trop importante. Pour être efficace, le spreader doit être très bon conducteur de la chaleur, par exemple en cuivre. Toutefois le cuivre est lourd, c'est pourquoi l'aluminium est aussi beaucoup utilisé. De plus, la conductivité thermique du cuivre est limitée (400 W.m⁻¹.K⁻¹). Ainsi, l'augmentation dans de grandes proportions de la surface d'un spreader ne permet alors pas de diminuer la résistance thermique globale car le flux de chaleur n'atteint pas les extrémités du spreader.

Pour améliorer la gestion thermique globale, il est donc intéressant d'utiliser des matériaux dont la conductivité thermique équivalente est plus élevée. Une solution consiste à utiliser des matériaux très bons conducteurs de la chaleur comme des matériaux chargés par des particules à forte conductivité thermique (diamant, carbone, ...). Mais de tels matériaux ne sont pas, à l'heure actuelle, suffisamment matures pour pouvoir être intégrés dans des équipements avec des coûts et des performances (fiabilité, usinage, conductivité obtenue, masse) compatibles aux exigences industrielles. Une autre solution couramment envisagée est l'utilisation de caloducs. Comme illustré sur la figure 2, un caloduc 15 est constitué d'une enceinte fermée 16 dont les parois internes sont recouvertes par un réseau capillaire 17 saturé de liquide 18. Il est généralement composé de trois parties appelées évaporateur 20, condenseur 21 et zone adiabatique 22. Au niveau de l'évaporateur 20, le liquide 18 se transforme en vapeur 23 qui se dirige vers le condenseur 21. Après condensation, le liquide est ramené vers l'évaporateur grâce au réseau capillaire 17 qui joue le rôle de moteur du caloduc. Avec un réseau capillaire adapté, le caloduc 15 peut fonctionner dans toutes les positions et par conséquent hors gravité. L'intérêt essentiel du principe caloduc est qu'il génère entre la zone d'évaporation 20 (source chaude) et la zone de condensation 21 (source froide) une différence de température très faible. Le caloduc joue le rôle d'un « court circuit thermique ». La zone vapeur des caloducs étant une zone à conductivité thermique équivalente très élevée, il est possible de les utiliser comme spreader. La figure 3 illustre le fonctionnement d'un tel caloduc 27 utilisé comme épanouisseur de chaleur. On parle alors d'épanouisseur de chaleur ou de « vapour chamber ». Le principe de fonctionnement est le même que celui des caloducs classiques mais les trajets du fluide sont différents car la source chaude 25 (évaporateur) est placée sur une première face du caloduc et la source froide 26 (condenseur) utilise l'intégralité de la seconde face.

Les solutions de type fluide diphasique (caloduc, « vapour chamber ») présentent des limitations. Par exemple en aéronautique, parmi les limitations les plus contraignantes, on peut citer le choix du fluide, la tenue aux accélérations, les performances pour des densités très fortes. Le fluide utilisé doit être compatible des contraintes aéronautiques (contrainte feu, règlement européen Reach, ....). De plus, la performance de ces solutions dépend fortement des caractéristiques de la source froide et du fluide diphasique utilisé.

Il existe aujourd'hui des exemples de boucles de refroidissement pour les systèmes électroniques faisant appel à des fluides conducteurs (sels fondus ou métaux liquides) mis en mouvement par des pompes électromagnétiques de type magnétohydrodynamique à courant continu (DC). Une boucle de refroidissement définie dans le document référencé [1] en fin de description utilise ainsi une pompe magnétohydrodynamique à conduction (MHD DC) pour un fluide conducteur de type Galn (Gallium-Indium) afin de refroidir un composant électronique. La pompe génère une pression de l'ordre de 25 kPa avec un débit de 0.14 litre.min⁻¹, alors que le champ magnétique appliqué dans la pompe est de 0.9 T. Ce système est capable de refroidir une densité de flux de chaleur supérieure à 200 W.cm⁻². Dans une telle boucle :
- Le point de fusion du Gallium-Indium est supérieur à 0°C, ce qui entraine un problème de fonctionnement à des températures ambiantes inférieures à la température de fusion. La source froide étant loin du composant électronique, la mise en route du dispositif peut devenir impossible avant la surchauffe du composant.
- L'alimentation de la pompe électromagnétique (fort courant/faible tension) est complexe et dispose d'un faible rendement.
- Une telle boucle fonctionnant avec un métal liquide ou sel fondu offre de bonnes performances thermiques. Néanmoins, elle est limitée à des applications particulières car les fluides conducteurs sont très chers (1000 euros/kg) et certains des métaux liquides comme le gallium ou les alliages de gallium ont une masse volumique six fois plus grand que celle de l'eau.

Le document référencé [2] décrit un spreader, dans lequel un métal liquide, par exemple du gallium ou un alliage de gallium tel que Gallium-Indium-Etain, est mis en circulation dans des canaux usinés dans celui-ci, au dessous d'un ou plusieurs composants semi-conducteur. Ce métal liquide absorbe la chaleur sous le ou les composants semi-conducteurs et distribue cette chaleur sur toute la surface restante. Ce métal liquide est mis en mouvement par l'intermédiaire d'une pompe magnétohydrodynamique à conduction, qui est intégrée dans le spreader. Le dépôt d'un matériau de protection permet de réaliser une isolation entre les parois du canal et le métal liquide afin d'éviter les interactions chimiques entre eux. Un tel spreader présente les inconvénients suivants : il nécessite un dépôt chimique (« coating ») pour isoler les parois du canal du métal liquide. Aucun remède contre la dilatation du gallium, lorsque celui-ci se solidifie, n'est prévu ; une telle dilatation pouvant endommager le spreader.

L'invention a pour objet de pallier ces inconvénients en proposant de mettre en circulation un métal liquide dans un spreader réalisé à partir d'un empilement de plusieurs plaques compatibles chimiquement avec le gallium, le métal liquide absorbant la chaleur sous la source de chaleur avec de faibles élévations de température et distribuant cette chaleur sur toute la surface restante du spreader, un dissipateur intégré sur la face au dessous du spreader permettant d'évacuer la chaleur du métal liquide.

Deux documents de l'art antérieur sont analysés ci-dessous.

US2010/066178 décrit un ensemble de pompe magnétique pour une intégration avec un spreader thermique mécaniquement flexible. L'ensemble peut comporter un boîtier qui peut être connectée à un substrat mécaniquement flexible du spreader thermique. L'ensemble peut comprendre en outre une pluralité d'aimants qui peuvent être intégrés avec et entourés par le boîtier. Les aimants permettent d'appliquer un champ magnétique à un liquide électriquement conducteur, et peuvent être mis en oeuvre en combinaison avec des électrodes, qui peuvent être intégrées avec le substrat pour la génération d'un flux de courant électrique à travers le liquide. Les aimants et les électrodes peuvent être combinés pour fournir une force de pompage pour faire circuler le liquide dans un canal intérieur d'une boucle de refroidissement électriquement conductrice du substrat. L'ensemble peut en outre comprendre un insert métallique rigide thermiquement conducteur intégré avec le boîtier. L'ensemble peut favoriser la conductivité thermique locale du spreader thermique.

US2006/158849 décrit un procédé et un appareil pour le refroidissement d'une source de chaleur à semi-conducteur. Dans un mode de réalisation un spreader thermique comprend un substrat pour supporter la source de chaleur à semi-conducteur et un dissipateur de chaleur couplé au substrat. Un canal est disposé entre le dissipateur de chaleur et le substrat. Le canal a au moins une paroi définie par le dissipateur de chaleur. La surface de la paroi du canal définie par le dissipateur de chaleur est d'environ 10 à environ 100 fois la surface spécifique de la surface de fond de la source de chaleur à semi-conducteur. Un liquide de refroidissement, par exemple un métal liquide, circule dans le canal.

### EXPOSÉ DE L'INVENTION

L'invention concerne un dispositif électronique avec refroidissement d'une source de dissipation de chaleur, par un spreader à métal liquide, ce dispositif comprenant au moins une source de dissipation de chaleur comportant au moins un composant électronique, au moins un spreader percé d'au moins un canal de circulation de métal liquide formant une boucle passant au dessous d'une source de dissipation de chaleur, au moins un dissipateur de chaleur et au moins une pompe électromagnétique de mise en mouvement du métal liquide dans ledit au moins un canal de manière à ce que le métal liquide absorbe la chaleur dissipée par une source de dissipation de chaleur et la transporte pour être évacuée par un dissipateur de chaleur, dans lequel chaque spreader comporte au moins deux plaques en matériau isolant électrique disposées de part et d'autre d'au moins un barreau en matériau déformable, caractérisé en ce qu'au moins un canal de circulation du métal liquide est réalisé autour d'au moins un tel barreau en matériau déformable.

Avantageusement le au moins un composant électronique peut être un composant semi-conducteur. Le métal liquide peut être choisi parmi : gallium, indium, bismuth, étain, alliages comprenant du gallium ou/et de l'indium ou/et de l'étain, alliage sodium-potassium. Avantageusement chaque barreau en matériau déformable est réalisé en téflon expansé, en mousse à cellules fermées, en mousse à cellules ouvertes avec revêtement étanche, ou en plastique déformable massif ou creux. Les électrodes sont en molybdène, en tungstène, en inox ou en cuivre recouvert d'une protection (« Coating »). Cette dernière solution permet de diminuer la chute de tension globale donc le rendement de la pompe électro-magnétique. Le dissipateur de chaleur est un dissipateur à ailettes, associé ou non avec un ventilateur, ou un refroidisseur à convection forcée liquide. Chaque pompe électromagnétique peut être une pompe magnétohydrodynamique à conduction (MHD DC). Elle peut être intégrée entre les deux plaques en matériau isolant électrique d'un spreader. Ces plaques en matériau isolant électrique peuvent être réalisées en céramique, en AIN, en Al203, en Si₃N₄ ou en SiC.

Avantageusement le spreader comporte des ailettes à l'intérieur du au moins un canal de circulation de métal liquide pour augmenter la surface d'échange avec le métal liquide.

Avantageusement le dispositif de l'invention comprend un ensemble pompe électromagnétique + un empilement de plusieurs composants semi-conducteurs/spreader à métal liquide/dissipateur.

Avantageusement un caloduc est disposé entre le spreader à métal liquide et le dissipateur de chaleur.

Avantageusement, dans un premier mode de réalisation, le dispositif de l'invention comprend :
- un premier circuit magnétique comprenant au moins un barreau de matériau magnétique et un aimant permanent,
- un premier cadre en polymère,
- une première plaque en matériau isolant électrique sur laquelle sont disposés des composants semi-conducteurs,
- un barreau en matériau déformable,
- trois électrodes, une étant disposée sur le matériau déformable,
- un joint en polymère avec des moyens de maintien,
- une seconde plaque en matériau isolant électrique,
- un second cadre en polymère,
- un second circuit magnétique,
- un dissipateur de chaleur,
un canal de circulation de métal liquide étant réalisé autour du barreau en matériau déformable.

Avantageusement, dans un second mode de réalisation, le dispositif de l'invention comprend :
- deux premiers circuits magnétiques,
- un cadre en polymère,
- une première plaque en céramique sur laquelle sont disposés des composants semi-conducteurs,
- un barreau en matériau déformable,
- des électrodes dont une électrode disposée sur le matériau déformable,
- un joint en polymère avec des moyens de maintien,
- une seconde plaque en céramique,
- deux seconds circuits magnétiques,
- un dissipateur de chaleur à ailettes,
un canal de circulation de métal liquide étant réalisé autour du barreau en matériau déformable.

Avantageusement, dans un troisième mode de réalisation, le dispositif de l'invention comprend :
- un premier dissipateur de chaleur à ailettes,
- un premier cadre en polymère,
- des premiers circuits magnétiques,
- une première plaque en céramique sur laquelle sont disposées des composants semi-conducteurs,
- des premières électrodes,
- trois premiers barreaux en matériau déformable,
- un premier joint en polymère avec des moyens de maintien,
- une seconde plaque en céramique,
- un second joint en polymère avec des moyens de maintien,
- des secondes électrodes,
- trois seconds barreaux en matériau déformable,
- une troisième plaque en céramique,
- des seconds circuits magnétiques,
- un second cadre en polymère,
- un second dissipateur de chaleur à ailettes,
un premier canal de circulation de métal liquide étant réalisé autour des premiers barreaux en matériau déformable, et un second canal de circulation de métal liquide étant réalisé autour des seconds barreaux en matériau déformable.

Le dispositif de l'invention présente les avantages suivants :
- La forte conductivité du spreader permet d'évacuer des densités de flux de chaleur beaucoup plus importantes que celles atteintes avec des caloducs. Des valeurs atteignant le kW/cm² sont envisagées.
- La compacité du spreader permet d'utiliser un très petit volume de métal liquide (quelques millilitres). Elle permet aussi de maintenir la source de dissipation de chaleur proche de tout le volume de liquide et d'obtenir une fusion de ce dernier en totalité. Une remise en route après solidification est possible.
- Une fusion peut être recherchée afin d'utiliser le changement de phase pour ralentir la montée en température du ou des composants électroniques. Ainsi, l'utilisation d'alliages à plus forte température de fusion et ne contenant pas de gallium est envisageable.

### BRÈVE DESCRIPTION DES DESSINS

La figure 1 illustre le principe de fonctionnement d'un dispositif de refroidissement de type spreader.
La figure 2 illustre le principe de fonctionnement d'un caloduc.
La figure 3 illustre le principe de fonctionnement d'un caloduc utilisé comme un épanouisseur de chaleur.
La figure 4 illustre le dispositif de l'invention. La figure 5 illustre le principe de fonctionnement d'une pompe électromagnétique utilisée dans le dispositif de la figure 4.
Les figures 6A et 6B illustrent un premier mode de réalisation du dispositif de l'invention respectivement dans une vue en éclaté et dans une vue en relief.
La figure 7 illustre schématiquement le fonctionnement d'une pompe électromagnétique utilisée dans le dispositif de l'invention illustré sur les figures 6A et 6B.
Les figures 8A et 8B illustrent un second mode de réalisation du dispositif de l'invention respectivement dans une vue en éclaté et dans une vue en relief.
Les figures 9A et 9B illustrent un troisième mode de réalisation du dispositif de l'invention respectivement dans une vue en éclaté et dans une vue en relief.
La figure 11 illustre les performances comparées d'un spreader à métal liquide selon l'invention illustré sur la figure 10A et d'un spreader en cuivre illustré sur la figure 10B.
Les figures 12A à 12B illustrent une variante de réalisation du dispositif de l'invention.
La figure 13 illustre une autre variante de réalisation du dispositif de l'invention.

### EXPOSÉ DÉTAILLÉ DE MODES DE RÉALISATION PARTICULIERS

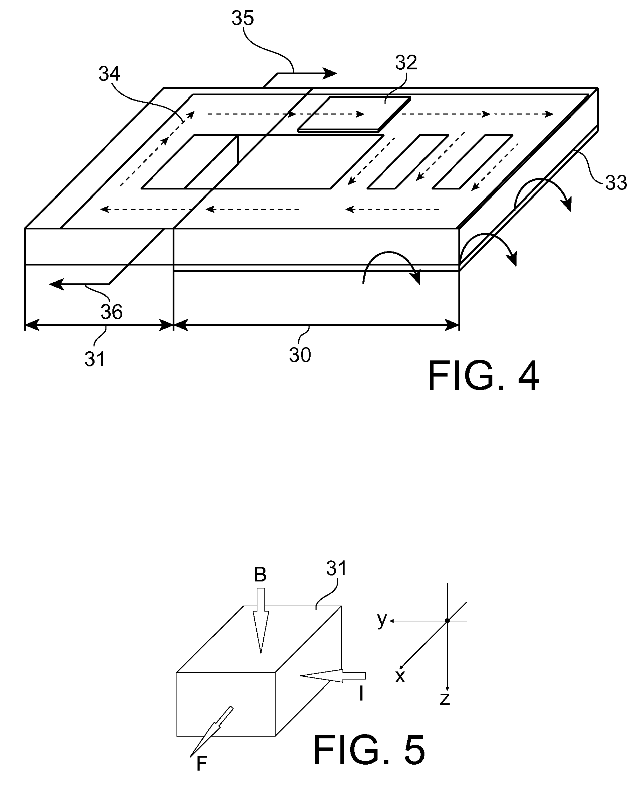

Comme illustré sur la figure 4, le dispositif de l'invention comprend les éléments suivants :
- une source de dissipation de chaleur 32, qui comporte au moins un composant électronique par exemple un composant semi-conducteur,
- un spreader à métal liquide 30, qui est la partie hydraulique servant à évacuer la chaleur au dessous de la source de dissipation de chaleur, réalisé à partir de deux plaques en matériau isolant électrique, par exemple en céramique, disposées de part et d'autre d'un matériau déformable autour duquel est réalisé un canal de circulation d'un métal liquide,
- une pompe électromagnétique 31 qui permet de mettre le métal liquide en mouvement,
- un dissipateur de chaleur 33.

La source de dissipation de chaleur 32 est disposée sur la face supérieure du spreader 30. Un dissipateur de chaleur 33 est disposé sur la face inférieure du spreader 30. La référence 34 illustre la circulation de métal liquide dans au moins un canal, dans lequel on peut ajouter des ailettes pour augmenter la surface d'échange. La référence 35 illustre l'entrée du métal liquide et la référence 36 la sortie du métal liquide.

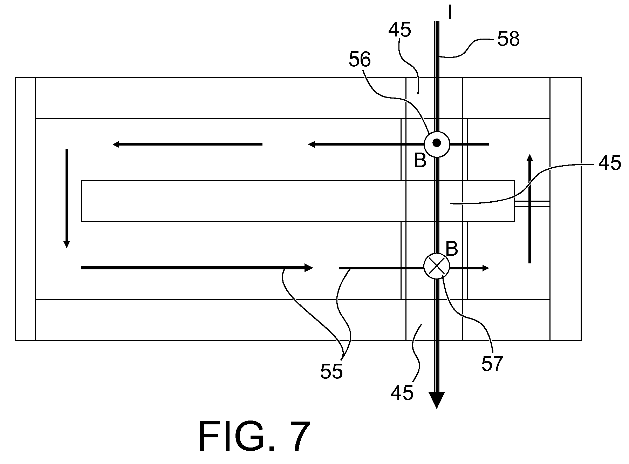

Le dispositif de l'invention met en circulation un métal liquide, qui est le fluide caloporteur, dans un substrat conducteur thermique. Ce métal liquide absorbe la chaleur sous les composants électroniques 32 avec de faibles élévations de température et distribue cette chaleur sur toute la surface restante du substrat. Les métaux liquides comme les alliages de gallium ou les sels fondus comme le sodium-potassium, possèdent d'excellentes propriétés physiques. Ainsi, le gallium qui possède une conductivité thermique proche de 28 W. m⁻¹.K⁻¹ valeur qui est 40 fois plus grande que celle de l'eau, permet d'atteindre des coefficients d'échanges convectifs très importants et donc une dissipation très importante en termes de densité de flux de chaleur. Outre leurs fortes conductivités thermiques, les métaux liquides ont aussi pour avantage d'être de bons conducteurs électriques, ce qui rend possible l'utilisation de pompes électromagnétiques ou magnétohydrodynamiques 31, comme celle illustrée sur les figures 5 et 7, dans lesquelles l'utilisation couplée d'un champ magnétique (induction magnétique B) et d'un courant électrique I créent une force de Laplace F entraînant le métal liquide en mouvement.

L'invention permet de mettre en circulation un métal liquide à l'intérieur d'un spreader réalisé à partir d'un empilement d'au moins deux plaques en matériau isolant électrique compatible chimiquement avec le gallium, et d'un barreau en matériau déformable qui sert à absorber la dilatation du gallium lors de sa solidification. La pompe électromagnétique qui sert à mettre en mouvement le métal liquide peut être intégrée entre les deux plaques. Ce métal liquide absorbe la chaleur sous la source de chaleur avec de faibles élévations de température et distribue cette chaleur sur toute la surface restante du spreader. Le dissipateur, qui sert à évacuer la chaleur dans le métal liquide, est reporté sur une surface du spreader.

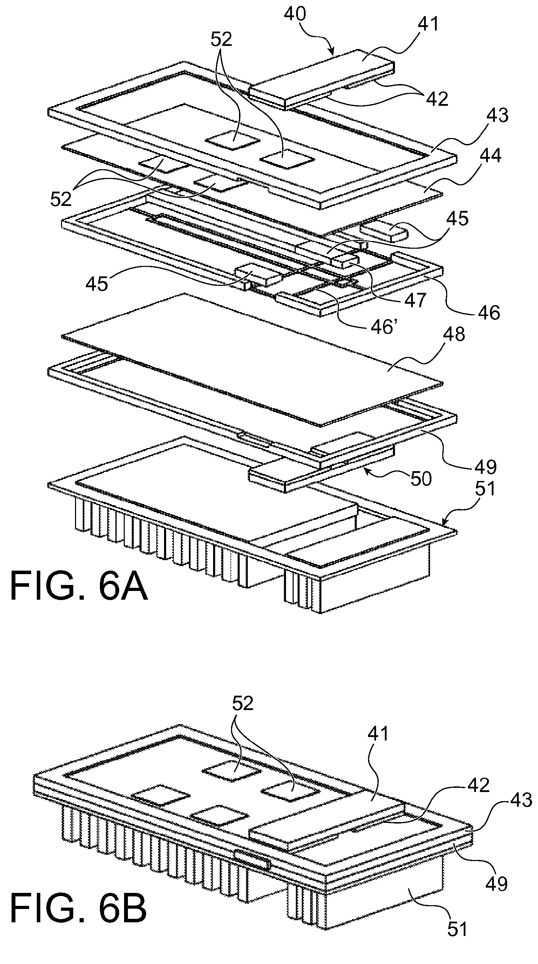

Les figures 6A et 6B illustrent un premier mode de réalisation du dispositif de l'invention comprenant deux pompes électromagnétiques comportant chacune un premier et un second circuits électromagnétiques générant un champ magnétique, et des électrodes véhiculant un courant électrique.

On distingue sur la figure 6A :
- un premier circuit magnétique 40 comprenant au moins un barreau de matériau magnétique 41 et un aimant permanent 42,
- un premier cadre en polymère 43,
- une première plaque en matériau isolant électrique 44 sur laquelle sont disposés des composants semi-conducteurs 52,
- un barreau en matériau déformable 47,
- trois électrodes 45, une étant disposée sur le matériau déformable,
- un joint en polymère 46 avec des moyens de maintien 46',
- une seconde plaque en matériau isolant électrique 48,
- un second cadre en polymère 49,
- un second circuit magnétique 50,
- un dissipateur de chaleur 51,
un canal de circulation du métal liquide étant réalisé autour du barreau en matériau déformable 52.

Dans un exemple avantageux de réalisation le dispositif de l'invention présente les caractéristiques suivantes :

Le métal liquide peut être choisi parmi : gallium, indium, bismuth, étain, alliages comprenant du gallium ou/et de l'indium ou/et de l'étain, alliage sodium-potassium.

Le rôle du polymère dans l'invention est d'assurer l'étanchéité du spreader ainsi que la tenue mécanique de l'empilement, les cadres servant comme boîtier pour le dispositif de l'invention. Ce polymère peut être une résine. Lors de l'assemblage des différents éléments illustrés sur la figure 6A, le polymère des cadres de polymère 43, 46 et 49 est mou. Il se solidifie ensuite, lorsqu'on le laisse sécher.

Les barreaux en matériau déformable peuvent être réalisés en téflon expansé, en mousse à cellules fermées, en mousse à cellules ouvertes avec revêtement étanche, ou en plastique déformable massif ou creux.

Avantageusement les deux plaques en matériau isolant électrique peuvent être réalisées en céramique, en AIN, en Al2O3, en Si₃N₄ ou en SiC qui tous respectent les trois contraintes suivantes : compatibilité chimique avec le gallium, isolation électrique et bonne conductivité thermique.

Le matériau des électrodes, qui doit être conducteur électrique et compatible avec le gallium, peut être le molybdène, le tungstène, l'inox ou le cuivre recouvert par une couche de protection.

Les aimants permanents qui servent à créer le champ magnétique dans le canal peuvent être en NdFeB.

Le dissipateur de chaleur peut être un dissipateur à ailette, associé à un ventilateur ou non, un refroidisseur à convection forcée liquide.

La figure 7 illustre le fonctionnement d'une pompe électromagnétique. Elle est formée du premier circuit magnétique 40 et du second circuit magnétique 50 et des électrodes 45, le canal de circulation du métal liquide étant formé autour du barreau en matériau déformable 52. La flèche 58 indique le sens du courant électrique traversant les électrodes. Les flèches 56 et 57 donnent le sens de l'induction magnétique B formée entre les deux circuits magnétiques 40 et 50. Les flèches 55 donnent le sens de déplacement du métal liquide qui en résulte, conformément au principe décrit ci-dessus au vu de la figure 5.

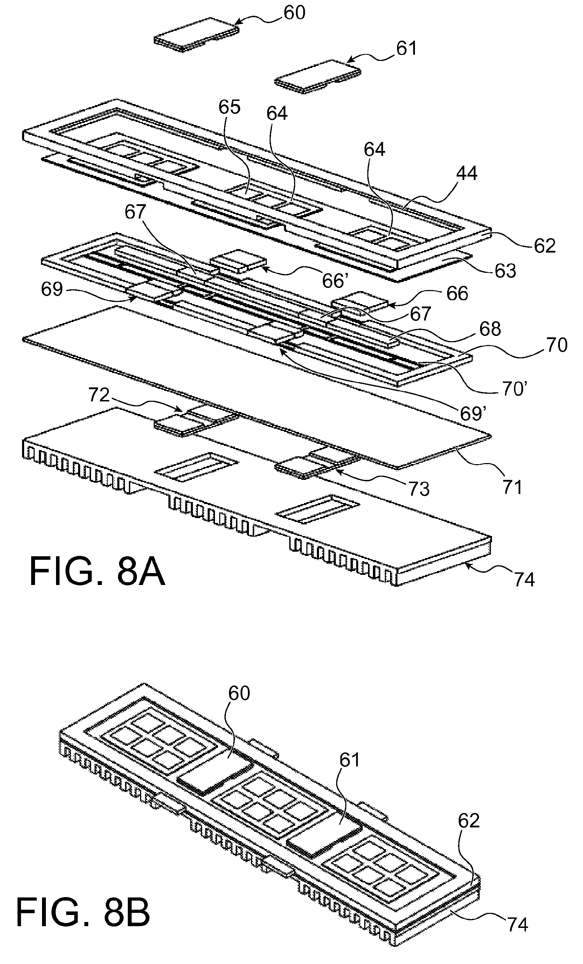

Les figures 8A et 8B illustrent un second mode de réalisation du dispositif de l'invention, qui correspond à un modèle de puissance comportant quatre pompes électromagnétiques.

On distingue sur la figure 8A :
- deux premiers circuits magnétiques 60 et 61,
- un cadre en polymère 62,
- une première plaque en céramique 63, sur laquelle sont disposés des circuits électronique 64 ou plusieurs composants électroniques 65,
- un barreau en matériau déformable 68,
- des électrodes 66, 66', 69, 69' et des électrodes 67 disposées sur le matériau déformable 68,
- un joint en polymère 70 avec des moyens de maintien 70',
- une seconde plaque en céramique 71,
- deux seconds circuits magnétiques 72 et 73,
- un dissipateur de chaleur à ailettes 74,
un canal de circulation du métal liquide étant réalisé autour du barreau en matériau déformable 68.

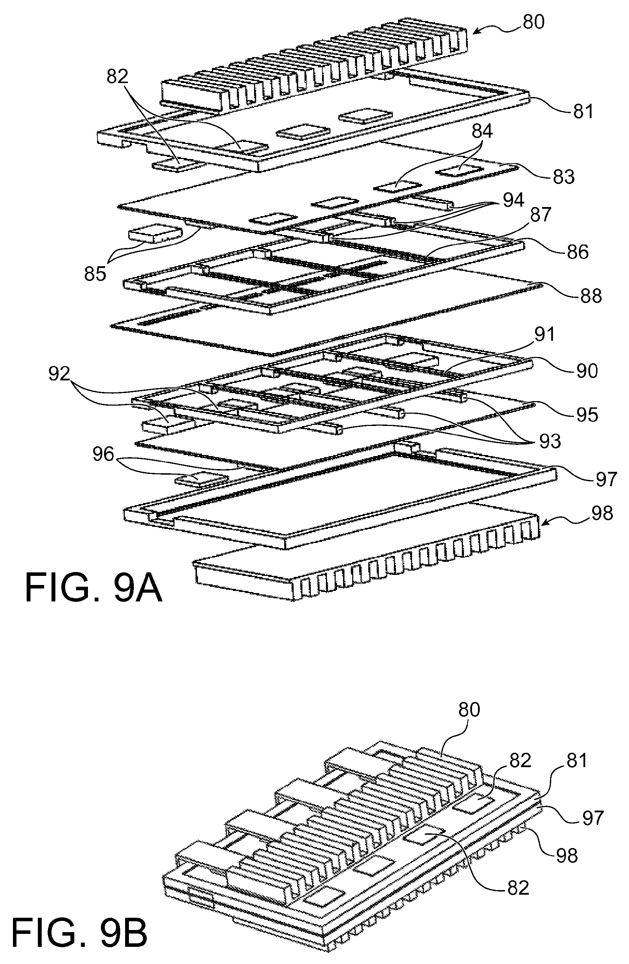

Les figures 9A et 9B illustrent un troisième mode de réalisation du dispositif de l'invention, qui correspond à un modèle à deux canaux superposés de circulation de métal liquide.

Sur la figure 9A on distingue :
- un premier dissipateur de chaleur à ailettes 80,
- un premier cadre en polymère 81,
- des premiers circuits magnétiques 82,
- une première plaque en céramique 83 sur laquelle sont disposés des composants semi-conducteurs 84,
- des premières électrodes 85,
- trois premiers barreaux en matériau déformable 94,
- un premier joint en polymère 86, avec des moyens de maintien 87,
- une seconde plaque en céramique 88,
- un second joint en polymère 90 avec des moyens de maintien 91,
- des secondes électrodes 92,
- trois seconds barreaux en matériau déformable 93,
- une troisième plaque en céramique 95,
- des seconds circuits magnétiques 96,
- un second cadre en polymère 97,
- un second dissipateur de chaleur à ailettes 98,
un premier canal de circulation de métal liquide étant réalisé autour des premiers barreaux en matériau déformable 92, et un second canal de circulation de métal liquide étant réalisé autour des seconds barreaux en matériau déformable 93.

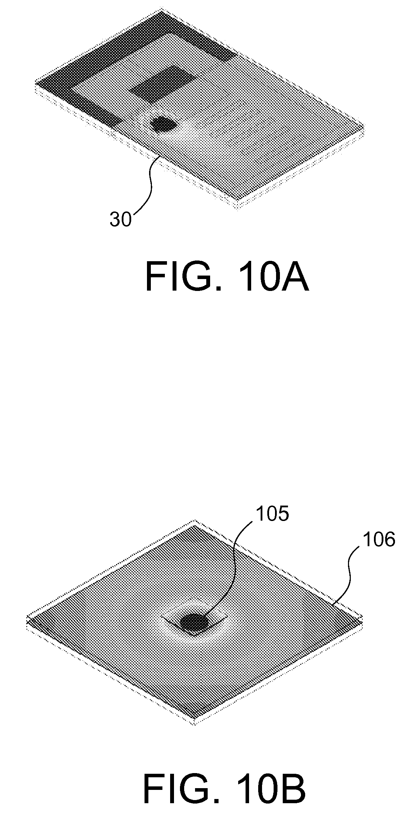

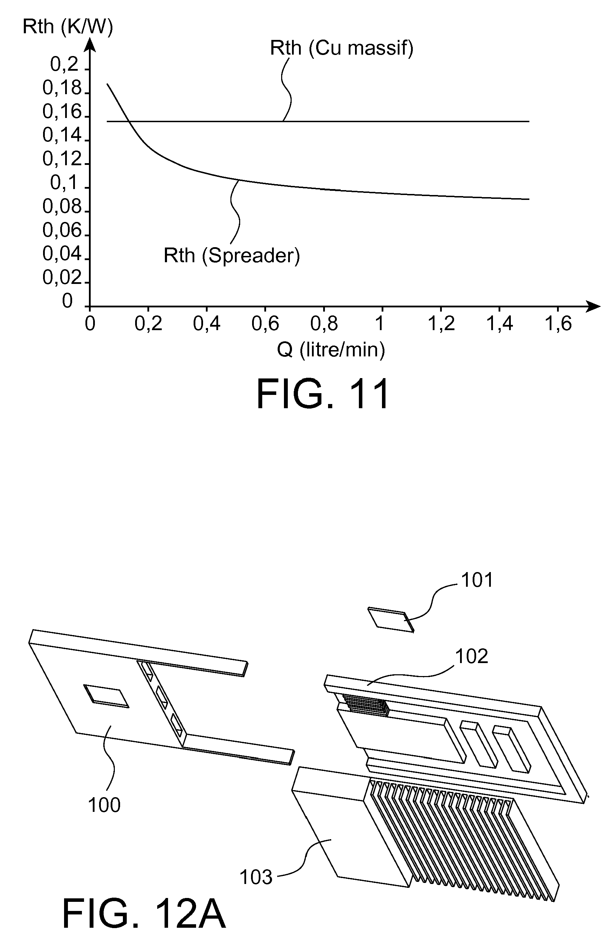

Afin de montrer l'intérêt d'un spreader tel que décrit ci-dessus, on peut comparer ses performances avec celles d'un bloc massif de cuivre de même volume. La valeur du coefficient d'échange imposée sur la surface opposée au composant électronique est la même dans les deux types de spreader, h = 20000 W.m⁻².K⁻¹. La figure 10A illustre ainsi un spreader à métal liquide 30 selon l'invention (voir figure 4) et la figure 10B un spreader formé d'un bloc de cuivre. Dans ce dernier cas, la source de dissipation 105 est au centre du spreader 106 car cette configuration permet d'obtenir la plus petite résistance thermique possible. La figure 11 présente l'évolution de la résistance thermique Rth de ces deux types de spreader en fonction du débit de métal liquide. La résistance thermique du spreader massif en cuivre est constante de valeur 0.16 K.W-1, par contre la résistance thermique du spreader à métal liquide, pour un débit de 1,5 1/min, est 0.09 K.W-1, ce qui correspond à une diminution de 45%.

### Variantes de réalisation

L'invention peut être utilisée dans différents domaines comme celui de la micro-électronique, notamment pour le refroidissement des microprocesseurs, celui de l'électronique de puissance, pour le refroidissement de composants semi-conducteurs, celui de l'optoélectronique, pour le refroidissement des LED, ou celui de l'énergie solaire, pour des cellules photovoltaïques à concentration.

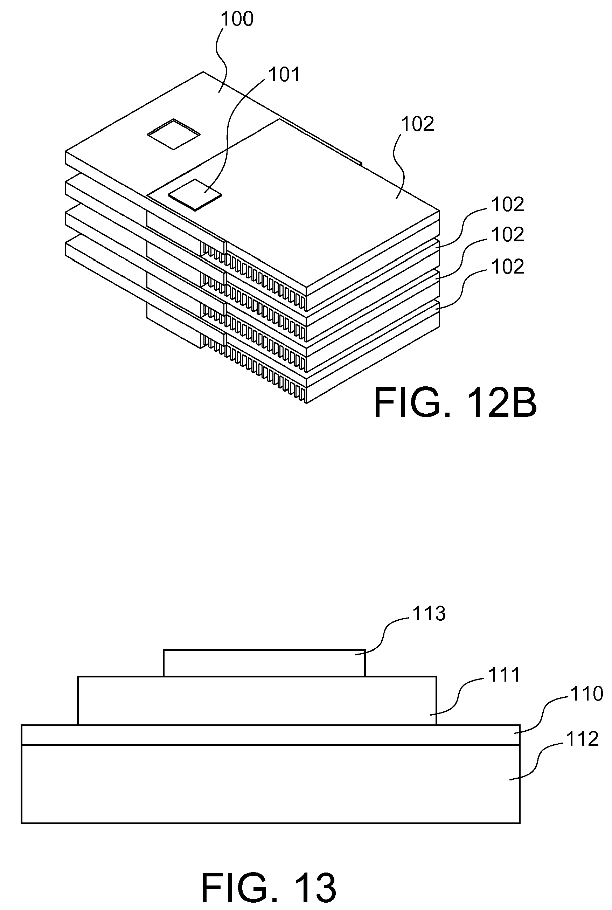

Les figures 12A et 12B illustrent une variante de réalisation du dispositif de l'invention en utilisant des empilements de plusieurs ensembles composants semi-conducteurs montés verticalement (module de puissance 3D) 101/spreader à métal liquide 102/dissipateur de chaleur 103, associés chacun à une pompe électromagnétique 100.

Dans une autre variante de réalisation illustrée sur la figure 13, un caloduc 110 peut être ajouté entre le spreader à métal liquide 111 et le dissipateur de chaleur 112, pour homogénéiser la température du spreader et améliorer encore ses performances. Le changement de phase du métal liquide à l'intérieur du spreader, dans ce cas, est meilleur. Par ailleurs, l'introduction du spreader à métal liquide 111 entre la source de dissipation 113, qui est un composant semi-conducteur, et le caloduc permet de diminuer la densité de chaleur vue par le caloduc et ainsi d'éloigner ses limites de fonctionnement (limite capillaire et limite d'ébullition en particulier).

Dans une variante de réalisation le spreader comporte des ailettes à l'intérieur du canal de circulation de métal liquide pour augmenter la surface d'échange avec le métal liquide, comme illustré par exemple sur les figures 10A et 12A.

### Références

[1] Miner, A. & Ghoshal, U., 2004. Cooling of high-power-density microdevices using liquid metal coolants. Applied Physics Letters, 85(3), 506.
[2] US 2009/0279257.

## Revendications

1. Dispositif électronique avec refroidissement d'une source de dissipation de chaleur par un spreader à métal liquide, ce dispositif comprenant au moins une source de dissipation de chaleur (32) comportant au moins un composant électronique, au moins un spreader (30) percé d'au moins un canal de circulation de métal liquide formant une boucle passant au dessous d'une source de dissipation de chaleur (32), au moins un dissipateur de chaleur (33) et au moins une pompe électromagnétique (31) de mise en mouvement du métal liquide (34) dans ledit au moins un canal de manière à ce que le métal liquide absorbe la chaleur dissipée par une source de dissipation de chaleur et la transporte pour être évacuée par un dissipateur de chaleur, dans lequel chaque spreader comporte au moins deux plaques en matériau isolant électrique disposées de part et d'autre d'au moins un barreau en matériau déformable, **caractérisé en ce qu'**au moins un canal de circulation du métal liquide est réalisé autour d'au moins un tel barreau en matériau déformable.

2. Dispositif selon la revendication 1, dans lequel le au moins un composant électronique est un composant semi-conducteur.

3. Dispositif selon la revendication 1, dans lequel le métal liquide est choisi parmi : gallium, indium, bismuth, étain, alliages comprenant du gallium ou/et de l'indium ou/et de l'étain, alliage sodium-potassium.

4. Dispositif selon la revendication 1, dans lequel chaque barreau en matériau déformable est réalisé en teflon expansé, en mousse à cellules fermées, en mousse à cellules ouvertes avec revêtement étanche, ou en plastique déformable massif ou creux.

5. Dispositif selon la revendication 1, dans lequel le dissipateur de chaleur est un dissipateur à ailettes, associé ou non à un ventilateur, ou un refroidisseur à convection forcée liquide.

6. Dispositif selon la revendication 1, dans lequel chaque pompe électromagnétique est une pompe magnétohydrodynamique à conduction.

7. Dispositif selon la revendication 1, dans lequel les plaques en matériau isolant électrique sont réalisées en céramique, en AIN, en Al203, en Si₃N₄ ou en SiC.

8. Dispositif selon la revendication 1, dans lequel chaque pompe électromagnétique est intégrée entre les deux plaques en matériau isolant électrique d'un spreader.

9. Dispositif selon la revendication 1, dans lequel le spreader comporte des ailettes à l'intérieur du au moins un canal de circulation de métal liquide pour augmenter la surface d'échange avec le métal liquide.

10. Dispositif selon la revendication 2 comprenant un ensemble pompe électromagnétique (100) et empilement de plusieurs composants semi-conducteurs (101)/spreader à métal liquide (102)/dissipateur (103).

11. Dispositif selon l'une quelconque des revendications précédentes dans lequel un caloduc (110) est disposé entre le spreader à métal liquide (111) et le dissipateur de chaleur (112).

12. Dispositif selon la revendication 1, comprenant :
- un premier circuit magnétique (40) comprenant au moins un barreau de matériau magnétique (41) et un aimant permanent (42),
- un premier cadre en polymère (43),
- une première plaque en matériau isolant électrique (44) sur laquelle sont disposés des composants semi-conducteurs (52),
- un barreau en matériau déformable (47),
- trois électrodes (45) une étant disposée sur le barreau en matériau déformable,
- un joint en polymère (46) avec des moyens de maintien (46'),
- une seconde plaque en matériau isolant électrique (48),
- un second cadre en polymère (49),
- un second circuit magnétique (50),
- un dissipateur de chaleur (51),
un canal de circulation de métal liquide étant réalisé autour du barreau en matériau déformable.

13. Dispositif selon la revendication 1, comprenant :
- deux premiers circuits magnétiques (60 et 61),
- un cadre en polymère (62),
- une première plaque en céramique (63) sur laquelle sont disposés plusieurs composants semi-conducteurs(65),
- un barreau en matériau déformable (68),
- des électrodes (66, 66', 69, 69') dont une électrode (67) disposée sur le matériau déformable (68),
- un joint en polymère (70) avec des moyens de maintien (70'),
- une seconde plaque en céramique (71),
- deux seconds circuits magnétiques (72 et 73),
- un dissipateur de chaleur à ailettes (74),
un canal de circulation de métal liquide étant réalisé autour du barreau en matériau déformable.

14. Dispositif selon la revendication 1, comprenant :
- un premier dissipateur de chaleur à ailettes (80),
- un premier cadre en polymère (81),
- des premiers circuits magnétiques (82),
- une première plaque en céramique (83) sur laquelle sont disposés des composants semi-conducteurs (84),
- des premières électrodes (85),
- trois premiers barreaux en matériau déformable (94),
- un premier joint en polymère (86) avec des moyens de maintien (87),
- une seconde plaque en céramique (88),
- un second joint en polymère (90) avec des moyens de maintien (91),
- des secondes électrodes (92),
- trois seconds barreaux en matériau déformable (93),
- une troisième plaque en céramique (95),
- des seconds circuits magnétiques (96),
- un second cadre en polymère (97),
- un second dissipateur de chaleur à ailettes (98),
un premier canal de circulation de métal liquide étant réalisé autour des premiers barreaux en matériau déformable et un second canal de circulation de métal liquide étant réalisé autour des seconds barreaux en matériau déformable.

15. Dispositif, selon l'une quelconque des revendications 12, 13 ou 14, dans lequel les électrodes sont en molybdène, en tungstène, en inox ou en cuivre avec une couche de protection.

## Patentansprüche

1. Elektronische Vorrichtung mit Kühlung einer Wärmeabstrahlquelle durch einen Flüssigmetallspreader, wobei diese Vorrichtung wenigstens eine Wärmeabstrahlquelle (32), die wenigstens ein elektronisches Bauelement umfasst, wenigstens einen Spreader (30), der von wenigstens einem Kanal zum Zirkulieren von Flüssigmetall, welcher eine unterhalb einer Wärmeabstrahlquelle (32) verlaufende Schleife bildet, durchbohrt ist, wenigstens einen Wärmeableiter (33) und wenigstens eine elektromagnetische Pumpe (31) umfasst, um das Flüssigmetall (34) in dem wenigstens einen Kanal in Bewegung zu versetzen, so dass das Flüssigmetall die durch eine Wärmeabstrahlquelle abgestrahlte Wärme aufnimmt und sie befördert, damit sie durch einen Wärmeableiter abgeführt wird, wobei jeder Spreader wenigstens zwei Platten aus elektrischem Isoliermaterial umfasst, die auf beiden Seiten wenigstens eines Stabes aus verformbarem Material angeordnet sind, **dadurch gekennzeichnet, dass** wenigstens ein Kanal zum Zirkulieren von Flüssigmetall um wenigstens einen solchen Stab aus verformbarem Material herum ausgebildet ist.

2. Vorrichtung nach Anspruch 1, bei der das wenigstens eine elektronische Bauelement ein Halbleiterbauelement ist.

3. Vorrichtung nach Anspruch 1, bei der das Flüssigmetall ausgewählt ist aus: Gallium, Indium, Wismut, Zinn, Legierungen, die Gallium und/oder Indium und/oder Zinn umfassen, Natrium-Kalium-Legierung.

4. Vorrichtung nach Anspruch 1, bei der jeder Stab aus verformbarem Material aus expandiertem Teflon, aus geschlossenzelligem Schaumstoff, aus offenzelligem Schaumstoff mit dichter Beschichtung oder aus massivem oder hohlem, verformbarem Kunststoff gefertigt ist.

5. Vorrichtung nach Anspruch 1, bei der der Wärmeableiter ein Rippen-Kühlkörper, der mit einem Ventilator verknüpft ist oder nicht, oder ein Kühler mit flüssiger Zwangskonvektion ist.

6. Vorrichtung nach Anspruch 1, bei der jede elektromagnetische Pumpe eine magnetohydrodynamische Konduktionspumpe ist.

7. Vorrichtung nach Anspruch 1, bei der die Platten aus elektrischem Isoliermaterial aus Keramik, aus AlN, aus Al₂O₃, aus Si₃N₄ oder aus SiC gefertigt sind.

8. Vorrichtung nach Anspruch 1, bei der jede elektromagnetische Pumpe zwischen den beiden Platten aus elektrischem Isoliermaterial eines Spreaders integriert ist.

9. Vorrichtung nach Anspruch 1, bei der der Spreader Rippen innerhalb des wenigstens einen Kanals zum Zirkulieren von Flüssigmetall umfasst, um die Austauschfläche mit dem Flüssigmetall zu vergrößern.

10. Vorrichtung nach Anspruch 2, die eine Anordnung aus elektromagnetischer Pumpe (100) und Stapel von mehreren Halbleiterbauelementen (101) / Flüssigmetallspreader (102) / Kühlkörper (103) umfasst.

11. Vorrichtung nach einem der vorhergehenden Ansprüche, bei der ein Wärmerohr (110) zwischen dem Flüssigmetallspreader (111) und dem Wärmeableiter (112) angeordnet ist.

12. Vorrichtung nach Anspruch 1, umfassend:
- einen ersten magnetischen Kreis (40), der wenigstens einen Stab aus magnetischem Material (41) und einen Permanentmagneten (42) umfasst,
- einen ersten Polymerrahmen (43),
- eine erste Platte aus elektrischem Isoliermaterial (44), auf der Halbleiterbauelemente (52) angeordnet sind,
- einen Stab aus verformbarem Material (47),
- drei Elektroden (45), wobei eine auf dem Stab aus verformbarem Material angeordnet ist,
- eine Polymerdichtung (46) mit Haltemitteln (46'),
- eine zweite Platte aus elektrischem Isoliermaterial (48),
- einen zweiten Polymerrahmen (49),
- einen zweiten magnetischen Kreis (50),
- einen Wärmeableiter (51),
wobei ein Kanal zum Zirkulieren von Flüssigmetall um den Stab aus verformbarem Material herum ausgebildet ist.

13. Vorrichtung nach Anspruch 1, umfassend:
- zwei erste magnetische Kreise (60 und 61),
- einen Polymerrahmen (62),
- eine erste Keramikplatte (63), auf der mehrere Halbleiterbauelemente (65) angeordnet sind,
- einen Stab aus verformbarem Material (68),
- Elektroden (66, 66', 69, 69'), wovon eine Elektrode (67) auf dem verformbaren Material (68) angeordnet ist,
- eine Polymerdichtung (70) mit Haltemitteln (70'),
- eine zweite Keramikplatte (71),
- zwei zweite magnetische Kreise (72 und 73),
- einen Wärmeableiter mit Rippen (74),
wobei ein Kanal zum Zirkulieren von Flüssigmetall um den Stab aus verformbarem Material herum ausgebildet ist.

14. Vorrichtung nach Anspruch 1, umfassend:
- einen ersten Wärmeableiter mit Rippen (80),
- einen ersten Polymerrahmen (81),
- erste magnetische Kreise (82),
- eine erste Keramikplatte (83), auf der Halbleiterbauelemente (84) angeordnet sind,
- erste Elektroden (85),
- drei erste Stäbe aus verformbarem Material (94),
- eine erste Polymerdichtung (86) mit Haltemitteln (87),
- eine zweite Keramikplatte (88),
- eine zweite Polymerdichtung (90) mit Haltemitteln (91),
- zweite Elektroden (92),
- drei zweite Stäbe aus verformbarem Material (93),
- eine dritte Keramikplatte (95),
- zweite magnetische Kreise (96),
- einen zweiten Polymerrahmen (97),
- einen zweiten Wärmeableiter mit Rippen (98),
wobei ein erster Kanal zum Zirkulieren von Flüssigmetall um die ersten Stäbe aus verformbarem Material herum ausgebildet ist und wobei ein zweiter Kanal zum Zirkulieren von Flüssigmetall um die zweiten Stäbe aus verformbarem Material herum ausgebildet ist.

15. Vorrichtung nach einem der Ansprüche 12, 13 oder 14, bei der die Elektroden aus Molybdän, aus Wolfram, aus nicht rostendem Stahl oder aus Kupfer mit einer Schutzschicht bestehen.

## Claims

1. Electronic device with cooling of a heat dissipation source by a liquid metals spreader, this device comprising at least one heat dissipation source (32) comprising at least one electronic component, at least one spreader (30) through which at least one liquid metal circulation channel passes forming a loop routed below a heat dissipation source (32), at least one heat sink (33) and at least one electromagnetic pump (31) moving the liquid metal (34) in said at least one channel such that the liquid metal absorbs heat dissipated by a heat dissipation source and transports it to be evacuated by a heat sink, wherein each spreader comprises at least two plates made of an insulating material located on each side of at least one bar made of deformable material, **characterised in that** at least one liquid metal circulation channel is made around said at least one bar made of deformable material.

2. Device according to claim 1, in which the at least electronic component is a semiconductor component.

3. Device according to claim 1, in which the liquid metal is chosen from among gallium, indium, bismuth, tin, alloys including gallium and/or indium and/or tin, sodium-potassium alloy.

4. Device according to claim 1, in which each bar made of deformable material is made from expanded Teflon, foam with closed cells, foam with open cells and with sealed coating, or solid or hollow deformable plastic.

5. Device according to claim 1, in which the heat sink is a finned heat sink that may or may not be used with a fan or a forced convection liquid cooler.

6. Device according to claim 1, in which each electromagnetic pump is a magnetohydrodynamic conducting pump.

7. Device according to claim 1, in which the plates made of an insulating electrical material are made of ceramic, AIN, Al203, Si₃N₄ or SiC.

8. Device according to claim 1, in which each electromagnetic pump is included between the two plates of a spreader made of an insulating material.

9. Device according to claim 1, in which the spreader comprises fins inside the at least one liquid metal circulation channel to increase the exchange area with the liquid metal.

10. Device according to claim 2 comprising an electromagnetic pump (100) and a stack of several semiconductor (101)/liquid metals spreader (102)/heat sink (103) components.

11. Device according to any one of the previous claims in which a heat duct (110) is arranged between the liquid metals spreader (111) and the heat sink (112).

12. Device according to claim 1, comprising:
- a first magnetic circuit (40) comprising at least one bar made of a magnetic material (41) and a permanent magnet (42),
- a first polymer frame (43),
- a first plate made of an insulating material (44) on which semiconductor components (52) are placed,
- a bar made of deformable material (47),
- three electrodes (45) one being placed on the bar made of deformable material,
- a polymer seal (46) with support means (46'),
- a second plate made of an insulating material (48),
- a second polymer frame (49),
- a second magnetic circuit (50),
- a heat sink (51),
a liquid metal circulation channel being made around the bar made of deformable material.

13. Device according to claim 1, comprising:
- two first magnetic circuits (60 and 61),
- one polymer frame (62),
- a first ceramic plate (63) on which several semiconductor components (65) are placed,
- a bar made of deformable material (68),
- electrodes (66, 66', 69, 69') one of which (67) is placed on deformable material (68),
- a polymer seal (70) with support means (70'),
- a second ceramic plate (71),
- two second magnetic circuits (72 and 73),
- a finned heat sink (74),
a liquid metal circulation channel being made around the bar made of deformable material.

14. Device according to claim 1, comprising:
- a first finned heat sink (80),
- a first polymer frame (81),
- first magnetic circuits (82),
- a first ceramic plate (83) on which semiconductor components (84) are placed,
- first electrodes (85),
- three first bars made of deformable material (94),
- a first polymer seal (86) with support means (87),
- a second ceramic plate (88),
- a second polymer seal (90) with support means (91),
- second electrodes (92),
- three second bars made of deformable material (93),
- a third ceramic plate (95),
- second magnetic circuits (96),
- a second polymer frame (97),
- a second finned heat sink (98),
a first liquid metal circulation channel being made around the first bars made of deformable material, and a second liquid metal circulation channel being made around the second bars made of deformable material.

15. Device according to any one of claims 12, 13 or 14, in which the electrodes are made from molybdenum, tungsten, stainless steel or copper coated with a protective layer.
